# EUROPEAN PATENT SPECIFICATION

(11) **EP 2 662 191 B1**
(45) Date of publication and mention of the grant of the patent: **15.04.2015**
(21) Application number: 12167635.7
(22) Date of filing: 11.05.2012
(51) Int. Cl.: B26F 1/44, B21D 28/16, B32B 7/12, H05K 3/46, G06K 19/077

(54) **De-burring tool**
Entgratungswerkzeug
Outil d'ébavurage

(43) Date of publication of application: 13.11.2013
(73) Proprietor: Oberthur Technologies, 92300 Levallois-Perret (FR)
(72) Inventor: Huet, Mickael c/o IP Département, Oberthur Technologies, 92000 Nanterre (FR); Bosquet, Olivier c/o IP Département, Oberthur Tsechnologies, 92000 Nanterre (FR)
(74) Representative: Lefevre-Groboillot, David André

(56) References cited:
- WO-A1-01/88845
- DE-A1- 19 948 857
- JP-A- 8 099 131
- JP-A- 2005 278 316
- US-A- 3 724 305
- US-A1- 2007 095 176

## Description

### Field of the Invention

The invention relates to a de-burring tool and in particular, but not exclusively, a tool for use in the manufacture of chip and/or magnetic stripe cards.

### Background of the Invention

Data cards are of a generally rectangular shape, often with rounded corners and these cards are made using a pre-punching or cutting tool which scores or cuts out the outline of the shape of the card that is to be cut from a sheet of material. SIM cards are now often provided as a card that is held on a carrier card that is formed from a sheet of material with the SIM card being held within the body of the carrier card by connections between the SIM card and the carrier card. The SIM card when used by a user is pushed out of the carrier card, and the carrier card is then discarded. SIM cards can be made from a plastics based material or a paper based material and the process of making the cards is generally the same, using the same tool, except that different blades are used depending on the type of material to be cut.

To produce data carriers such as credit cards or SIM cards from a sheet of material it is necessary to have very accurate precutting or crushing of the card material so that the outline of the card is accurately marked out and there is a limitation in the burrs that are produced during forming an outline of the data carrier.

The present invention seeks to overcome the problems associated with the prior art by providing a de-burring tool and a method of manufacturing a card that avoid the problems associated with the prior art, which is the poor finishing of the edges of cards. In particular the present invention seeks to overcome problems associated with the prior art in that it allows for the manufacture of cards more quickly by avoiding the need for a separate finishing step.

Tools with a shoulder for cutting and subsequent de-burring are known from JP-A-2005 278316 and DE 19948857 A1 and provide the basis for the preamble of claim 1.

### Summary of the Invention

The present invention is defined in the appended set of claims.

According to a first aspect of the invention there is provided de-buring tool provided as a punch and die that are moveable relative to one another during operation to cut a substrate,
the punch having a cutting surface and at least one shearing surface provided as a shoulder on the punch behind the cutting surface,
the die having at least one primary surface that the cutting surface of the punch first passes during operation, followed by the shoulder, so that burrs formed by passage of the cutting surface past the primary surface of the die are removed by passage of the shoulder past the die, thereby providing a clean surface on the substrate that has been cut by the punch,
characterized in that the die is provided as two members each having a primary surface, the members being separated by a space to receive the cutting surface of the punch, wherein the two members can be moved back and forth to vary the tolerance between a cutting edge of the cutting surface and an inner edge of the die during operation.

Preferably the punch has a singular cutting surface with a shoulder on either side of the cutting surface for removal of burrs.

It is envisaged that the cutting surface of the punch is provided as a linear edge that is in substantially in the same plane as the primary surface of the die, when the punch and die meet.

It is envisaged that the die has a secondary surface substantially perpendicular to the primary surface which the cutting surface of the die passes followed by the shoulder.

Preferably there is a clearance between the cutting face of the punch and the secondary face of the die that is twice that of the distance between the shoulder of the punch and the secondary face of the die.

In a preferred arrangement there is a clearance between the cutting face and the secondary surface of 10 micrometers.

Preferably there is a clearance between a shoulder of the punch and the secondary surface of the die of 5 micrometers.

It is preferred that the die is provided as two members each having a primary surface, the members being separated by a space to receive the cutting surface of the punch.

In a first arrangement the die is provided as a two part die with the two members being held relative to one another in a chuck.

In a further arrangement the die is provided as a one part die with the two members being positioned at a predetermined distance from one another.

Preferably the substrate is a data carrier with a magnetic stripe or microchip.

It is envisaged that the substrate is a SIM card.

According to a second aspect of the invention there is provided a method of cutting a surface and de-burring of the cut surface in a single action whereby the punch and die are moved relative to one another during an operation to cut a substrate, wherein the cutting surface of the punch is caused to move past a primary surface on the die with the punch continuing to move past the primary surface so that a shoulder on the punch subsequently moves past the primary surface so that burrs formed by passage of the cutting surface past the primary surface of the die are removed by passage of the shoulder past the die, thereby providing a clean surface on the substrate that has been cut by the punch.

Preferably the punch and die move relative to one another in a vertical direction.

It is envisaged that the method is used to produce a data carrier and in particular a SIM card.

Preferably the method is used to remove burs from a plastic substrate and in particular a polycarbonate substrate.

### Brief Description of the Figures

An embodiment of the invention will be described with reference to and as illustrated in the accompanying figures by way of example only, in which:
Figure 1 shows: a punch and die according to an embodiment of the invention; and
Figure 2 shows: a series of steps in the cutting and de-burring of a substrate.

### Detailed Description of Embodiments of the Invention

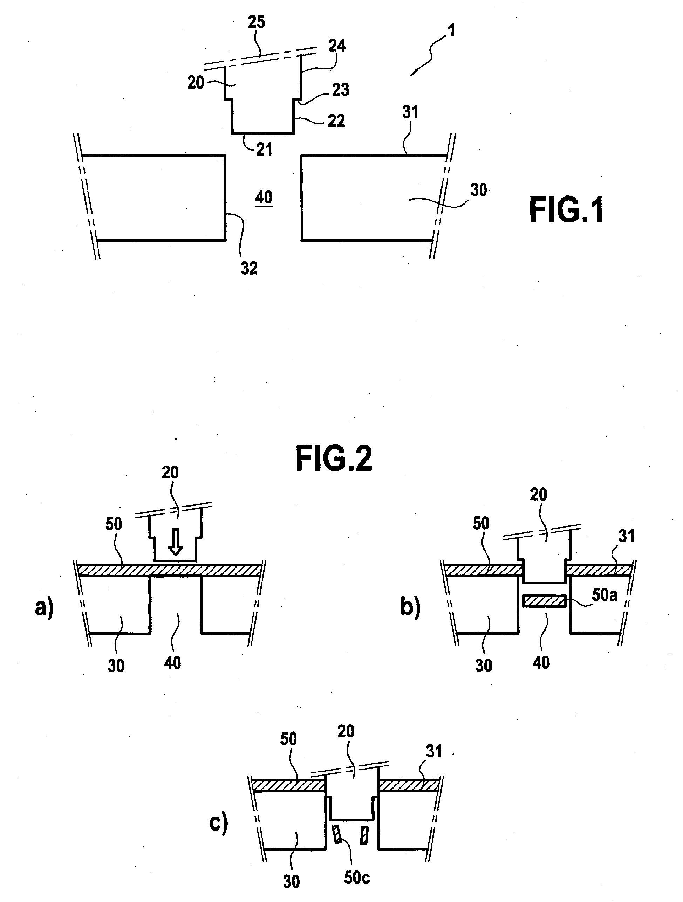

**Figure 1** shows generally a de-burring tool as 1. The tool is formed of a punch 20 and a die 30. The punch is a generally rectilinear shape with a cutting face 21 at a first end of the punch and a second opposite end 25 of the punch being held in a chuck (not shown) that can move the punch back and forth relative to the die. The movement preferably is in a vertical direction but it may also move horizontally depending on the orientation of the substrate that is to be cut.

The cutting face is parallel to a primary surface 31 of the punch. Leading back from the cutting surface 21 is a first cutting edge 22 of the punch which leads to a shoulder 23. The shoulder extends outwardly from the first edge 22 and extending from the shoulder is a further cutting edge 24. This gives the punch a stepped profile. As shown in the figure the profiles of both sides of the punch are symmetrical but it could be that just one side of the punch is stepped or the profiles may be asymmetrical.

With respect to the die 30, as shown in the figure, the die is formed with a space (cavity) 40 which accommodates the punch as it moves towards the die and past the primary surface 31.

The sequence of events that are involved in a cutting action are shown in Figure 2 as steps a) to c). At the start of the sequence a) the substrate to be cut 50, such as a SIM card is positioned on the primary surface 31 of the die 30 and above this is the punch 20. As shown in b) the punch moves past the primary surface 31 and cuts the substrate and the cut out part falls away as 50a. The cutting surface 21 follows through until the shoulder 23 passes the primary surface and any rough edges that have been left on the substrate are removed from the substrate edge and fall away as debris 50c.

The distance between the first cutting edge 22 and the inner edge 32 of the die as shown in Figure 1 is greater than that between the further cutting edge 24 and the inner edge of the die 32. This means that any debris that may protrude from the substrate that has been cut and which extends from the substrate will be cleaned by the shoulder 23 rubbing past the primary surface and removing any burrs.

This cleaning process can be used with many types of cards, including SIM cards or cards having push out stickers for use in electronic devices such as mobile phones. In particular the process and apparatus can be used with cards having a polycarbonate structure and this material is particularly difficult to punch out cleanly. Other plastics that could form the card include Polyethylene terephthalate (PET), e.g. Polyethylene Terephthalate Glycol (PETg) or Polyethylene Terephthalate Film (PETf).

Typical clearances are 10 micrometers between the face 22 and the face 32. The clearance for the face 24 and the die 32 is 5 micrometers. If the die is formed of one piece or then these tolerances will be predefined. However it is conceivable that if a two part die is used then the two parts of the die can be moved back and forth to vary the tolerances, depending on the material that is being punched.

It is to be understood that the above embodiments have been provided only by way of exemplification of this invention, such as those detailed below, and that further modifications and improvements thereto, as would be apparent to persons skilled in the relevant art, are deemed to fall within the broad scope and ambit of the present invention described. Furthermore where individual embodiments are discussed, the invention is intended to cover combinations of those embodiments as well.

## Claims

1. A de-burring tool (1) provided as a punch (20) and die (30) that are moveable relative to one another during operation to cut a substrate (50), the punch having a cutting surface (21) and at least one shearing surface provided as a shoulder (23) on the punch behind the cutting surface,
the die having at least one primary surface (31) that the cutting surface (21) of the punch first passes during operation, followed by the shoulder (23), so that burrs (50c) formed by passage of the cutting surface past the primary surface of the die are removed by passage of the shoulder past the die, thereby providing a clean surface on the substrate (50) that has been cut by the punch,
**characterized in that** the die (30) is provided as two members each having a primary surface (31), the members being separated by a space (40) to receive the cutting surface (21) of the punch, wherein the two members can be moved back and forth to vary the tolerance between a cutting edge (22) of the cutting surface (21) and an inner edge (32) of the die (30) during operation.

2. A de-burring tool according to claim 1 wherein the punch has a single cutting (21) surface with a shoulder (23) on either side of the cutting surface for removal of burrs.

3. A de-burring tool according to claim 1 or claim 2, wherein the cutting surface (21) of the punch is provided as a linear edge that is in substantially in the same plane as the primary surface (31) of the die, when the punch (20) and die (30) meet.

4. A de-burring tool according to any preceding claim wherein the inner edge (32) is substantially perpendicular to the primary surface (31) which the cutting surface (21) of the die passes followed by the shoulder (23) during operation of the de-burring tool.

5. A de-burring tool according to any preceding claim wherein there is a clearance between the cutting edge (22) of the cutting surface (21) of the punch and the inner edge (32) of the die that is twice that of the distance between the shoulder (23) of the punch and the inner edge (32) of the die.

6. A de-burring tool according to any preceding claim wherein the clearance between the first edge (22) and the inner edge (32) of the die is 10 micrometers.

7. A de-burring tool according to any preceding claim wherein the clearance between an edge (24) of the shoulder (23) of the punch and the inner edge (32) of the die is 5 micrometers.

8. A de-burring tool according to any preceding claim wherein the die (30) is provided as a two part die with the two members being held relative to one another in a chuck.

9. A de-burring tool according to any preceding claim wherein the substrate (50) is a data carrier with a magnetic stripe or microchip.

10. A de-burring tool according to claim 9, wherein the data carrier is an ID-1 card.

11. A method of cutting a substrate (50) and de-burring of the cut substrate in a single action, the method being implemented by a de-burring tool according to any preceding claim, whereby the punch (20) and die (30) are moved relative to one another during operation to cut the substrate, wherein the cutting surface (21) of the punch is caused to move past the primary surface (31) on the die with the punch continuing to move past the primary surface into the space (40) associated with the die so that the shoulder (23) on the punch subsequently moves past the primary surface (31) so that burrs formed by passage of the cutting surface past the primary surface of the die are removed by passage of the shoulder past the die, thereby providing a clean surface on the substrate that has been cut by the punch.

12. A method according to claim 11, wherein the punch (20) and die (30) move relative to one another in a vertical direction.

13. A method according to any of claims 11 or 12, wherein the substrate is a plastic substrate.

## Patentansprüche

1. Entgratwerkzeug (1), bereitgestellt als Stanze (20) und Matrize (30), die während des Betriebs gegeneinander beweglich sind, um ein Substrat (50) zu schneiden, wobei die Stanze eine Schneidfläche (21) und mindestens eine Scherfläche hat, die als Schulter (23) an der Stanze hinter der Schneidfläche bereitgestellt ist, wobei die Matrize mindestens eine primäre Fläche (31) hat, an der zuerst die Schneidfläche (21) während des Betriebs vorbeiläuft, gefolgt von der Schulter (23), so dass Grate (50c), die durch den Durchgang der Schneidfläche an der primären Fläche der Matrize vorbei gebildet werden, durch den Durchgang der Schulter an der Matrize entfernt werden, so dass eine saubere Fläche auf dem Substrat (50), die durch die Stanze geschnitten wurde, bereitgestellt wird,
**dadurch gekennzeichnet, dass** die Matrize (30) in Form von zwei Elementen bereitgestellt wird, von denen jedes eine primäre Fläche (31) hat, wobei die Elemente durch einen Abstand (40) getrennt sind, um die Schneidfläche (21) der Stanze aufzunehmen, wobei die beiden Elemente vor- und zurückbewegt werden können, um die Toleranz zwischen einer Schneidkante (22) der Schneidfläche (21) und einen Innenkante (32) der Matrize (30) während des Betriebs zu variieren.

2. Entgratwerkzeug nach Anspruch 1, wobei die Stanze eine einzelne Schneidfläche (21) mit einer Schulter (23) auf jeder Seite der Schneidfläche zum Entfernen von Graten hat.

3. Entgratwerkzeug nach Anspruch 1 oder 2, wobei die Schneidfläche (21) der Stanze als lineare Kante bereitgestellt wird, d.h. in im Wesentlichen derselben Ebene wie die primäre Fläche (31) der Matrize, wenn sich die Stanze (20) und die Matrize (30) treffen.

4. Entgratwerkzeug nach einem der vorherigen Ansprüche, wobei die Innenkante (32) im Wesentlichen senkrecht zur primären Fläche (31) ist, an der die Schneidfläche (21) der Matrize vorbeiläuft, gefolgt von der Schulter (23) während des Betriebs des Entgratwerkzeugs.

5. Entgratwerkzeug nach einem der vorherigen Ansprüche, wobei es einen Abstand zwischen der Schneidkante (22) der Schneidfläche (21) der Stanze und der Innenkante (32) der Matrize gibt, die gleich dem Doppelten des Abstandes zwischen der Schulter (23) der Stanze und der Innenkante (32) der Matrize ist.

6. Entgratwerkzeug nach einem der vorherigen Ansprüche, wobei der Abstand zwischen der ersten Kante (22) und der Innenkante (32) der Matrize 10 Mikrometer beträgt.

7. Entgratwerkzeug nach einem der vorherigen Ansprüche, wobei der Abstand zwischen einer Kante (24) der Schulter (23) der Stanze und der Innenkante (32) der Matrize 5 Mikrometer beträgt.

8. Entgratwerkzeug nach einem der vorherigen Ansprüche, wobei die Matrize (30) als zweiteilige Matrize bereitgestellt wird, wobei die zwei Elemente relativ zueinander in einer Spannvorrichtung gehalten werden.

9. Entgratwerkzeug nach einem der vorherigen Ansprüche, wobei das Substrat (50) ein Datenträger mit einem Magnetstreifen oder Mikrochip ist.

10. Entgratwerkzeug nach Anspruch 9, wobei der Datenträger eine ID-1-Karte ist.

11. Verfahren zum Schneiden eines Substrats (50) und zum Entgraten des geschnittenen Substrats in einer einzigen Aktion, wobei das Verfahren durch ein Entgratwerkzeug gemäß einem der vorhergehenden Ansprüche implementiert wird, wobei die Stanze (20) und Matrize (30) gegeneinander bewegt werden während des Betriebs zum Schneiden des Substrats, wobei bewirkt wird, dass die Schneidfläche (21) der Stanze an der primären Fläche (31) auf der Matrize vorbei bewegt, wobei die Stanze sich weiter vorbei an der primären Fläche in den Raum (40) bewegt, der mit der Matrize verbunden ist, so dass die Schulter (23) an der Stanze sich anschließend vorbei an der primären Fläche (31) bewegt, so dass Grate, die durch die Bewegung der Schneidfläche vorbei an der primären Fläche gebildet wurden, durch die Bewegung der Schulter vorbei an der Matrize entfernt werden, wodurch eine saubere Fläche auf dem Substrat bereitgestellt wird, die durch die Stanze geschnitten wurde.

12. Verfahren nach Anspruch 11, wobei die Stanze (20) und die Matrize (30) sich relativ zueinander in einer vertikalen Richtung bewegen.

13. Verfahren nach einem der Ansprüche 11 oder 12, wobei das Substrat ein Kunststoffsubstrat ist.

## Revendications

1. Outil d'ébavurage (1) réalisé sous forme d'un poinçon (20) et d'une matrice (30) qui sont mobiles l'un par rapport à l'autre en fonctionnement pour couper un substrat (50), le poinçon ayant une surface de coupe (21) et au moins une surface de cisaillement réalisée sous forme d'un épaulement (23) sur le poinçon en arrière de la surface de coupe, la matrice ayant au moins une surface principale (31) que la surface de coupe (21) du poinçon dépasse en premier en fonctionnement, suivi par l'épaulement (23), de sorte que des bavures (50c) formées par le passage de la surface de coupe au-delà de la surface principale de la matrice sont éliminées par le passage de l'épaulement au-delà de la matrice, en réalisant ainsi une surface nette sur le substrat (50) qui a été coupé par le poinçon,
**caractérisé en ce que** la matrice (30) est réalisée sous forme de deux éléments ayant chacun une surface principale (31), les éléments étant séparés par un espace (40) pour recevoir la surface de coupe (21) du poinçon, dans lequel les deux éléments peuvent se déplacer en arrière et en avant pour faire varier, la tolérance entre un bord de coupe (22) de la surface de coupe (21) et un bord intérieur (32) de la matrice (30) en fonctionnement.

2. Outil d'ébavurage selon la revendication 1, dans lequel le poinçon comporte une seule surface de coupe (21) avec un épaulement (23), pour l'élimination des bavures, de chaque côté de la surface de coupe.

3. Outil d'ébavurage selon la revendication 1 ou la revendication 2, dans lequel la surface de coupe (21) du poinçon est réalisée sous forme d'un bord rectiligne qui est substantiellement dans le même plan que la surface principale (31) de la matrice, lorsque le poinçon (20) et la matrice (30) se rencontrent.

4. Outil d'ébavurage selon l'une quelconque des revendications précédentes, dans lequel le bord intérieur (32) est substantiellement perpendiculaire à la surface principale (31) que la surface de coupe (21) de la matrice dépasse suivie par l'épaulement (23) en fonctionnement de l'outil d'ébavurage.

5. Outil d'ébavurage selon l'une quelconque des revendications précédentes, dans lequel il y a un jeu entre le bord de coupe (22) de la surface de coupe (21) du poinçon et le bord intérieur (32) de la matrice qui est deux fois la distance entre l'épaulement (23) du poinçon et le bord intérieur (32) de la matrice.

6. Outil d'ébavurage selon l'une quelconque des revendications précédentes, dans lequel le jeu entre le premier bord (22) et le bord intérieur (32) de la matrice est de 10 micromètres.

7. Outil d'ébavurage selon l'une quelconque des revendications précédentes, dans lequel le jeu entre un bord (24) de l'épaulement (23) du poinçon et le bord intérieur (32) de la matrice est de 5 micromètres.

8. Outil d'ébavurage selon l'une quelconque des revendications précédentes, dans lequel la matrice (30) est réalisée sous forme d'une matrice en deux parties, les deux éléments étant maintenus l'un par rapport à l'autre dans un mandrin.

9. Outil d'ébavurage selon l'une quelconque des revendications précédentes, dans lequel le substrat (50) est un support de données avec une bande magnétique ou une puce électronique.

10. Outil d'ébavurage selon la revendication 9, dans lequel le support de données est une carte d'identification au format ID-1.

11. Procédé de coupe d'un substrat (50) et d'ébavurage du substrat coupé en une seule opération, le procédé étant mis en oeuvre par un outil d'ébavurage selon l'une quelconque des revendications précédentes, le poinçon (20) et la matrice (30) se déplaçant l'un par rapport à l'autre en fonctionnement pour couper le substrat, dans lequel la surface de coupe (21) du poinçon est amenée à se déplacer au-delà de la surface principale (31) de la matrice, le poinçon continuant à se déplacer au-delà de la surface principale dans l'espace (40) associé à la matrice de sorte que l'épaulement (23) sur le poinçon se déplace ensuite au-delà de la surface principale (31) de sorte que des bavures formées par le passage de la surface de coupe au-delà de la surface principale de la matrice sont éliminées par le passage de l'épaulement au-delà de la matrice, en réalisant ainsi une surface nette sur le substrat qui a été coupé par le poinçon.

12. Procédé selon la revendication 11, dans lequel le poinçon (20) et la matrice (30) se déplacent l'un par rapport à l'autre dans une direction verticale.

13. Procédé selon l'une quelconque des revendications 11 ou 12, dans lequel le substrat est un substrat en plastique.
